# EUROPEAN PATENT APPLICATION

(11) **EP 0 690 502 A1**
(43) Date of publication of application: **03.01.1996**
(21) Application number: 95109946.4
(22) Date of filing: 26.06.1995
(51) Int. Cl.: H01L 23/467

(54) **Cooling fin for semiconductor device**

(30) Priority: 27.06.1994 JP 144228/94
(71) Applicant: NEC CORPORATION, Tokyo (JP)
(72) Inventor: Saitoh, Takehiro, c/o NEC Corp., Minato-ku, Tokyo (JP)
(74) Representative: Glawe, Delfs, Moll & Partner

(57) **Abstract**

A cooling fin 1 is mounted to a semiconductor device having a semiconductor chip 2. The cooling fin 1 transfers heat evolved from the semiconductor chip 2 through an air current toward an external atmosphere. A plurality of fin plates 3 is disposed so that an interval between adjacent ones gradually becomes small (a₁>b₁, a₂>b₂ and a₃>b₃) as advancing from upstream to downstream of the air current. A column 4 supports and interconnects the plurality of fin plates 3 and the lower end portion of the column 4 is attached to the semiconductor device. The air current flows along a printed circuit board 12 on which the semiconductor device is mounted. Each of the plurality of fin plates 3 is disposed so as to assume an angle of attack relative to the air current as viewed from the side of the printed circuit board 12. The flow rate of the air current flowing between the adjacent fin plates 3 is accelerated to improve the thermal diffusibility of the cooling fin 1.

## Description

### FIELD OF THE INVENTION

The present invention relates to a cooling fin for semiconductor device and, in particular, to a cooling fin of air-cooling type adapted for semiconductor device, which utilizes gas such as air or the like as a cooling medium.

### BACKGROUND OF THE INVENTION

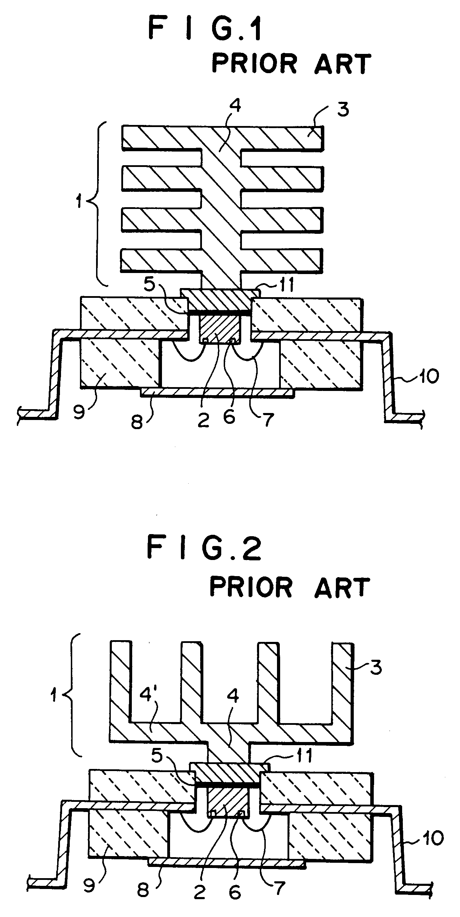

In a conventional semiconductor device loaded with a semiconductor chip having high output circuit elements of high power consumption great in evolving heat during operation, as shown in, for example, Fig. 1, a cooling fin 1 for semiconductor device (hereinafter referred to simply as cooling fin) which is obtained by cutting aluminum or copper have been mounted on its package so that the heat evolved from the circuit elements in the semiconductor chip may be transferred to the external atmosphere.

Referring to Fig. 1, reference numeral 2 denotes a semiconductor chip having an integrated circuit therein, which is loaded on the lower surface of a chip loading portion 5. On the upper surface of the chip loading portion 5, a cooling fin loading portion 11 is disposed. These portions 5 and 11 are mounted on a package body 9. An external lead 10 is mounted to the package body 9, the inner end of the external lead 10 and an electrode 6 of the integrated circuit of the semiconductor chip 2 are interconnected with a metallic thin wire 7, and the outer end of the external lead 10 extends toward the outside of the package body 9. Reference numeral 8 denotes a cap attached to the package body 9. The semiconductor device comprises the above members.

A cooling fin 1 is connected to the outer surface of the cooling fin loading portion 11. The cooling fin 1 comprises a plurality of fin plates 3 disposed in parallel in the horizontal direction and a column 4 on the order of 10 mm in diameter which connects and retains the fin plates, and are formed by cutting. The column 4 couples the center of each fin plate, and the lower end portion of the column 4 is joined to the cooling fin loading portion 11 to thereby transfer the heat evolved from the semiconductor chip 2 to each fin plate 3 efficiently.

Further, as another form of the conventional cooling fin, as shown in Fig. 2, a horizontal connection plate 4' is mounted to the column 4, and a plurality of upright fin plates 3, which are arrayed in parallel to each other, are mounted on the upper surface of the connection plate 4'.

If the semiconductor device mounted with the cooling fin 1 as described above is loaded on a printed circuit board or the like for operation, then a cooling medium such as air or the like is compulsorily blown against the cooling fin 1 in the direction along the printed circuit board to make the heat radiate from the surface of the fin plates 3.

In such conventional cooling fins 1, when a study is made in terms of the cross-section perpendicular to the direction of the upstream to downstream of the air current, resistance to the air current is great at the lower side, i.e. the portion at the side of the printed circuit board, because there are uneven portions or cooling fin 1 or package body 9, while it is small at the upper side, i.e. above the cooling fin 1. As a result, the air current flows at a high speed at the upper side, which does not contribute to heat radiation so much flowing toward the downstream, and at the lower side the air current stagnates thus resulting in lowered cooling capability.

In order to solve this problem, in Japanese Patent Application Laid-Open No. 61-13694, fin plates 3 of the cooling fin 1 are disposed inclined relative to the direction in which the cooling medium flows in such a way that they assume a positive angle of attack as viewed from the side of the printed circuit board, on which the semiconductor device is loaded, to thereby pull the air current flowing through the upper side toward the lower side by the reaction of lift to make much air current flow at the side of the printed circuit board while mixing the cooling medium appropriately, to eliminate separation of the upper and lower layers of the air current.

However, in this conventional cooling fin, since fin plates 3 assuming the angle of attack are disposed parallel to each other, the air current passing between the neighboring fin plates is gradually decelerated on the basis of the resistance of the fin plates, and the cooling capability at the downstream of the air current is reduced. The degree of reduction in the cooling capability is remarkable with the structure of Fig. 1, in which the column is present at the center, and with the structure of Japanese Patent Application Laid-Open No. 61-13694, and especially on the leeward of the column, an eddy air current remarkably slow as compared with that of the upstream results and the heat diffusibility of the cooling fin is aggravated.

### SUMMARY OF THE INVENTION

The present invention was made in view of the foregoing circumstances, and the object thereof is to provide a cooling fin adapted for semiconductor device in which the deceleration of the air cuurent between the fin plates is extremely small and the heat diffusibility is excellent.

According to the present invention, in order to achieve the foregoing end, there is provided a cooling fin which is mounted to a semiconductor device having a semiconductor chip, the cooling fin transferring heat evolved from the semiconductor chip through an air current toward an external atmosphere, comprising a plurality of fin plates disposed so that an interval between adjacent ones gradually becomes small as advancing from upstream to downstream of the air current, and a support member for supporting and interconnecting the plurality of fin plates, the support member having a portion for mounting to the semiconductor device.

It is preferable that the air current flows along a board on which the semiconductor device is mounted.

Each of the plurality of fin plates may be disposed so as to assume an angle of attack relative to the air current as viewed from the side of the board. Here, preferably, the support member couples central portions of the plurality of fin plates and the lower end portion of the support member is attached to the semiconductor device.

Each of the plurality of fin plates may be disposed so as to stand upright relative to the board. Here, preferably, lower end portions of the plurality of fin plates are interconnected by the support member and the lower end portion of the support member is attached to the semiconductor device.

According to the present invention, since the interval between the adjacent fin plates is made to gradually become small in the direction of the air current (that is, as advancing from the upstream to downstream of the air current) so that the air current passing through between the fin plates is gradually accelerated, the thermal resistance of the cooling fin can be made smaller, and the cooling fin excellent in heat diffusibility can be provided.

### BRIEF DESCRIPTION OF THE DRAWINGS

Fig. 1 is a cross-sectional view illustrating the structure of a conventional cooling fin and how to use it;
Fig. 2 is a cross-sectional view illustrating the structure of another conventional cooling fin and how to use it;
Fig. 3 is a cross-sectional view illustrating the structure of a first embodiment of the cooling fin according to the present invention and how to use it;
Fig. 4A is a plan view illustrating the cooling fin of this embodiment;
Fig. 4B is a cross-sectional view of the same taken along line A-A';
Fig. 4C is a frontal view of the cooling fin according to this embodiment;
Fig. 4D is a rear view of the cooling fin according to this embodiment;
Fig. 5 is a cross-sectional view illustrating the structure of a second embodiment of the cooling fin according to the present invention and how to use it;
Fig. 6 is a plan view illustrating how to use the cooling fin of this embodiment;
Fig. 7A is a lateral view illustrating the cooling fin of this embodiment;
Fig. 7B is a plan view of the cooling fin according to this embodiment;
Fig. 7C is a frontal view of the cooling fin according to this embodiment;
Fig. 7D is a rear view of the cooling fin of this embodiment; and
Fig. 8 is a diagram illustrating a relationship between the flow rate of the cooling air and the thermal resistance of the cooling fin.

### DESCRIPTION OF THE PREFERRED EMBODIMENTS

Some specific embodiments of the present invention are hereinafter described with reference to the drawings.

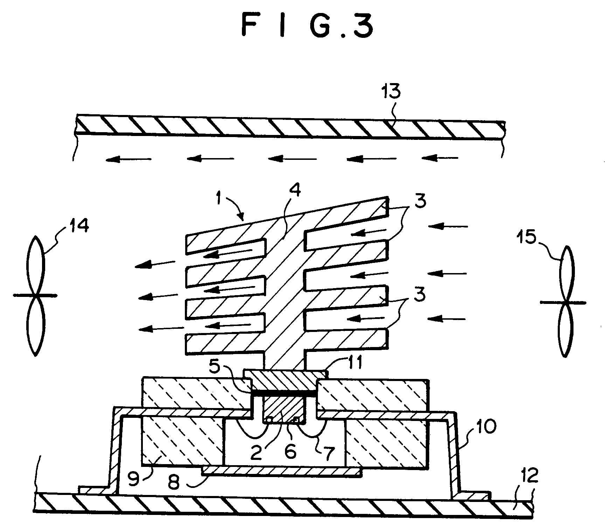

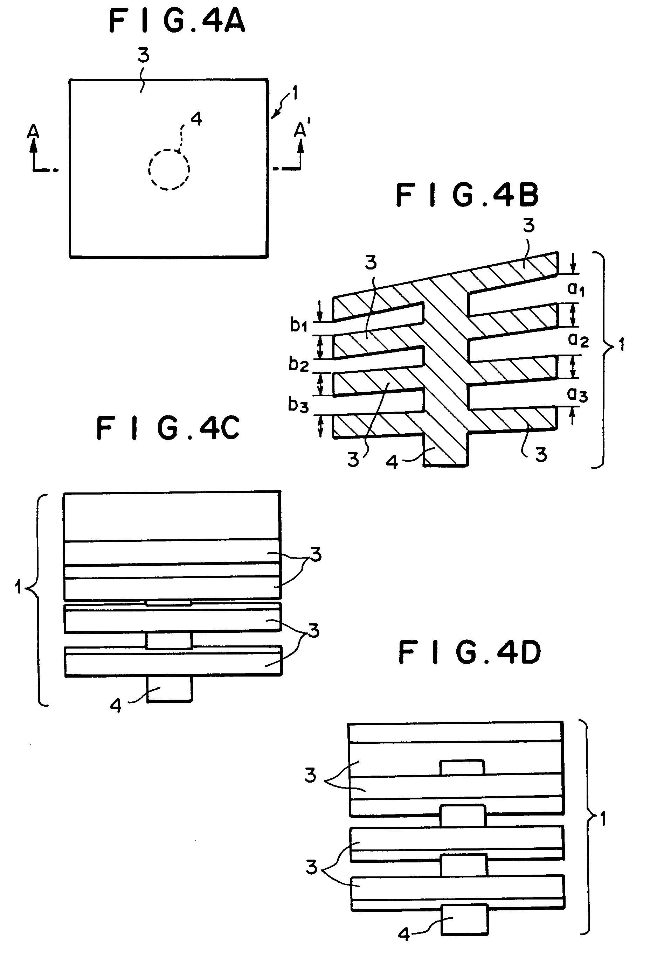

Fig. 3 is a cross-sectional view illustrating the structure of a first embodiment of the cooling fin according to the present invention and how to use it. Further, Fig. 4A is a plan view illustrating the cooling fin of this embodiment. Fig. 4B is a cross-sectional view of the same taken along line A-A'. Fig. 4C is a frontal view of the cooling fin of this embodiment. Fig. 4D is a rear view of the cooling fin of this embodiment.

In these figures, reference numeral 2 denotes a semiconductor chip having an integrated circuit therein, which is loaded on the lower surface of a chip loading portion 5. On the upper surface of the chip loading portion 5, a cooling fin loading portion 11 is disposed. These portions 5 and 11 are mounted on a package body 9. An external lead 10 is mounted to the package body 9, the inner end of the external lead 10 and an electrode 6 of the integrated circuit of the semiconductor chip 2 are interconnected with a metallic thin wire 7, and the outer end of the external lead 10 extends toward the outside of the package body 9. Reference numeral 8 denotes a cap attached to the package body 9. The semiconductor device comprises the above members.

A cooling fin 1 is connected to the outer surface of the cooling fin loading portion 11. The cooling fin 1 comprises a plurality of fin plates 3 and a column 4. The fin plates 3 are arrayed in vertical direction, and the central portion of each fin plate is coupled to and retained by means of the column 4, which extends down to the lower portion of the lowermost fin plate, the lower end portion of the column 4 being coupled to the upper surface of the cooling fin loading portion 11. It is intended to transfer the heat evolved at the semiconductor chip 2 to each fin plate 3 efficiently. The cooling fin 1 is made of a material excellent in thermal conduction such as aluminum, copper or the like, and can be manufactured by cutting or by welding or adhesion of the column 4 and the fin plates 3. The column 4 is used as a support member.

As shown in Fig. 3, a printed circuit board 12 loaded with a plurality of semiconductor devices each mounted with the cooling fin 1 as mentioned in the above and another printed circuit board 13 loaded with the semiconductor devices (not shown) are arrayed in parallel to each other. Then, fans 14, 15 are positioned to drive them so as to make the cooling air current flow from right to left as viewed in Fig. 3.

As shown, each fin plate 3 of the cooling fins 1 is disposed inclined so as to assume a positive angle of attack as viewed from the side of the printed circuit board 12, on which the semiconductor device bearing the cooling fin 1 is loaded, relative to the direction of the air current, and at the center, the column 4 is provided to support each fin plate 3 to transfer heat efficiently. Further, the interval between the adjacent upper and lower fin plates 3 is gradually reduced from upstream toward downstream of the air current as a₁>b₁, a₂>b₂ and a₃>b₃. Distances b₁, b₂ and b₃ are preferably within the range of 1 to 10 mm, e.g. 2mm and the fin plate 3 is inclined to the adjacent one preferably by an angle within the range of 2 to 8 degrees, e.g. 5 degrees.

Therefore, if the cooling air current flowing between the printed circuit boards 12, 13 reaches the cooling fin 1, then it is pulled toward the lower side on the basis of the reaction of the lift acted on the fin plates 3, and flows more toward the printed circuit board 12 to be mixed properly. As a result, the air current ceases to be separated into the upper and lower layers, and further the air current flowing between the adjacent fin plates 3 is concentrated between the fin plates 3, the interval between which is gradually narrowed with advance of the cooling air current, to cause the increase of the pressure and the flow rate to be accelerated resulting in improving the cooling capability.

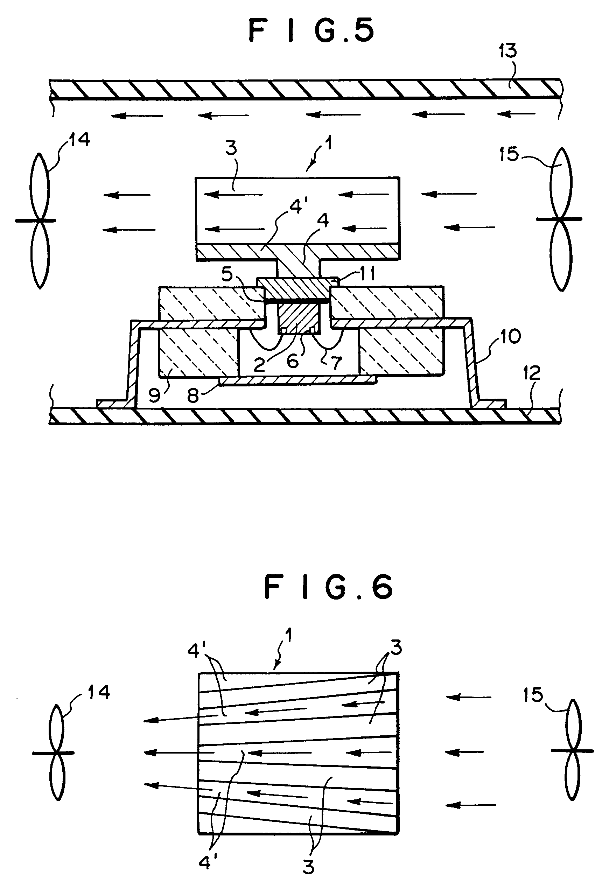

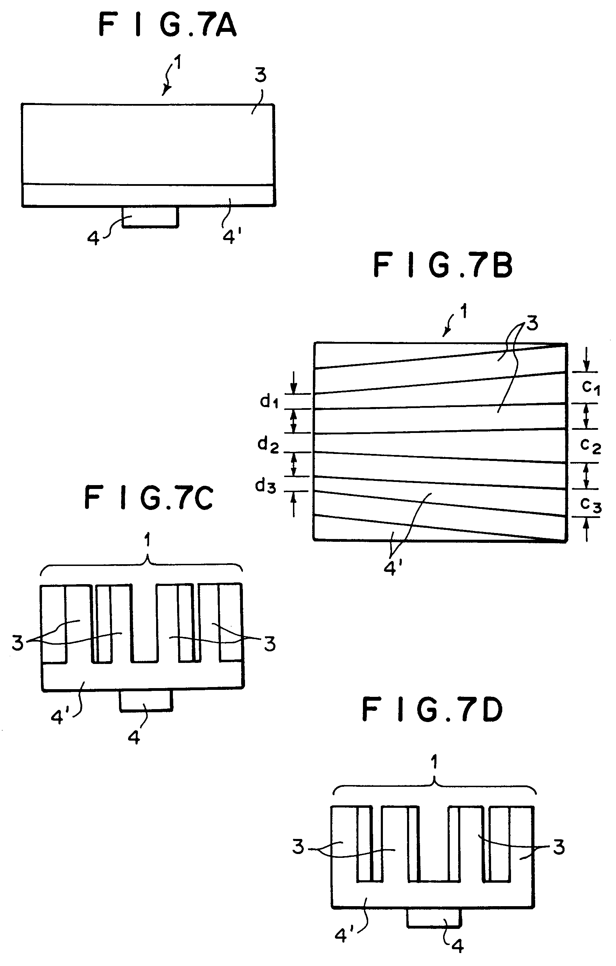

Fig. 5 is a cross-sectional view illustrating the structure of a second embodiment of the cooling fin according to the present invention and how to use it. Fig. 6 is a plan view illustrating how to use the cooling fin of this embodiment. Further, Fig. 7A is a lateral view illustrating the cooling fin of this embodiment. Fig. 7B is a plan view of the same. Fig. 7C is a frontal view of the cooling fin of this embodiment. Fig, 7D is a rear view of the cooling fin of this embodiment.

Referring to Figs. 5 and 6, the structure of the semiconductor device, loading of the semiconductor device onto the printed circuit boards 12, 13 and arrangement of these printed circuit boards 12, 13 and fans 14, 15 are similar as in the first embodiment.

In the cooling fin of this embodiment, each of the fin plates 3 is disposed so that it stands upright in the vertical direction relative to the board 12. The lower end portion of each fin plate 3 is coupled to the connecting plate 4', and the column 4 is coupled to the lower surface of the central portion of the connecting plate 4' and is coupled to the upper surface of the cooling fin loading portion 11. As in the first embodiment, the fin 1 is made of a material excellent in heat conduction such as aluminum, copper or the like, and can be manufactured by cutting, or by welding or adhesion of the column 4, connecting plate 4' and the fin plates 3. The combination of the column 4 and the connecting plate 4' is used as a support member.

As shown, the interval between the adjacent fin plates 3 is gradually reduced from upstream toward downstream of the air current and as shown in Fig. 7B, c₁>d₁, c₂>d₂ and c₃>d₃ result. Distances d₁, d₂ and d₃ are preferably within the range of 1 to 10 mm, e.g. 2 mm and the fin plate 3 is inclined to the adjacent one preferably by an angle within the range of 2 to 8 degrees, e.g. 5 degrees.

Therefore, if the cooling air current flowing between the printed circuit boards 12, 13 reaches the cooling fin 1, then the air current flowing between the adjacent fin plates 3 each disposed upright in the vertical direction is concentrated between the fin plates 3, the interval between which is gradually narrowed with advance of the cooling air current, to cause the increase of the pressure and the flow rate to be accelerated resulting in improving the cooling capability. In this embodiment, since there is no column between the fin plates 3 as different from the first embodiment, the resistance against the air current is correspondingly smaller, the flow rate is accelerated and the cooling effect is increased.

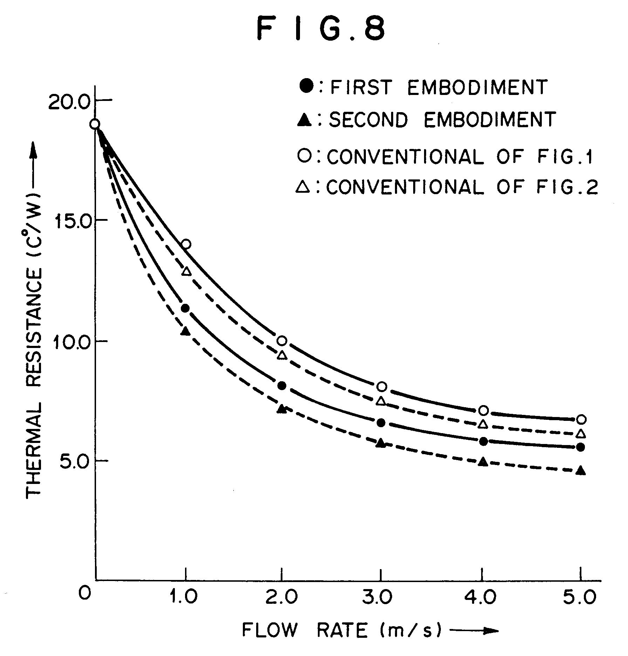

Fig. 8 is a diagram illustrating a relationship between the flow rate of the cooling air and the thermal resistance of the cooling fin as regard the cooling fin according to the present invention and the conventional one, in which a quad flat package semiconductor device comprising 208 pins utilizing ceramics as the package body 9 is used to show the result obtained by comparing the conventional cooling fin and the cooling fin according to the present invention. Here, a relationship between the flow rate of the air and the thermal resistance of the cooling fin was examined with reference to the first embodiment in which the plurality of fin plates 3 are disposed in such a manner that the lowermost one is inclined by an angle of 5 degrees to the horizontal plane and each upper one is inclined by an angle of 5 degrees to the adjacent, lower one, and to the second embodiment in which the plurality of fin plates 3 are disposed in such a manner that the adjacent ones are inclined by an angle of 5 degrees to each other, and to the conventional cooling fins of Figs. 1 and 2 corresponding to the above first and second embodiments respectively.

As can be seen in Fig. 8, in the first embodiment, the thermal resistance is lower than any of the conventional horizontal type cooling fin of Fig. 1 and the conventional vertical type cooling fin of Fig. 2, and the heat diffusibility is improved by the air current being accelerated between the fin plates. Further, in the second embodiment, a more remarkable improvement can be seen than the first embodiment, which is considered due to the fact that absence of the column between the fin plates lends itself to the improvement of the heat diffusibility.

Although heretofore some preferred embodiments were described, the present invention is not restricted to the foregoing embodiments, but various changes and modifications are possible within the scope not departing from the essence of the present invention.

## Claims

1. A cooling fin which is mounted to a semiconductor device having a semiconductor chip, said cooling fin transferring heat evolved from said semiconductor chip through an air current toward an external atmosphere, comprising:
a plurality of fin plates disposed so that an interval between adjacent ones gradually becomes small as advancing from upstream to downstream of said air current; and
a support member for supporting and interconnecting said plurality of fin plates, the support member having a portion for mounting to said semiconductor device.

2. A cooling fin as set forth in Claim 1, wherein said air current flows along a board on which said semiconductor device is mounted.

3. A cooling fin as set forth in Claim 2, wherein each of said plurality of fin plates is disposed so as to assume an angle of attack relative to said air current as viewed from the side of said board.

4. A cooling fin as set forth in Claim 3, wherein said support member couples central portions of said plurality of fin plates and the lower end portion of said support member is attached to said semiconductor device.

5. A cooling fin as set forth in Claim 2, wherein each of said plurality of fin plates is disposed so as to stand upright relative to said board.

6. A cooling fin as set forth in Claim 5, wherein lower end portions of said plurality of fin plates are interconnected by said support member and the lower end portion of said support member is attached to said semiconductor device.
